# EUROPEAN PATENT APPLICATION

(11) **EP 4 394 839 A1**
(43) Date of publication of application: **03.07.2024**
(21) Application number: 23211225.0
(22) Date of filing: 21.11.2023
(51) Int. Cl.: H01J 37/09

(54) **APPARATUS AND METHOD FOR FABRICATION OF SHIELD PLATE**

(30) Priority: 26.12.2022 JP 2022208823
(71) Applicant: Jeol Ltd., Akishima-shi, Tokyo 196-8558 (JP)
(72) Inventor: NEGISHI, Tsutomu, Tokyo, 196-8558 (JP); KOZUKA, Munehiro, Tokyo, 196-8558 (JP)
(74) Representative: Boult Wade Tennant LLP

(57) **Abstract**

There is provided a shield plate fabrication apparatus (100) capable of fabricating a shield plate (6) easily. The shield plate (6) is included in a sample milling apparatus (300) which mills a sample (S) by shielding a part of the sample (S) with the shield plate (6) and irradiating the sample (S) with a charged particle beam (IB). The fabrication apparatus (100) includes: a base plate holding shaft (10) for rotatably holding a base plate (2) and winding tape (4) around the base plate (2); and a tension mechanism (50) for applying tension to the tape (4) while it is being wound around the base plate (2).

## Description

### BACKGROUND OF THE INVENTION

### 1. Field of the Invention

The present invention relates to an apparatus and method for fabrication of a shield plate.

### 2. Description of the Related Art

Known sample milling apparatus for milling samples using an ion beam include Cross Section Polisher (trademark registered) for milling cross sections of samples and Ion Slicer (trademark registered) for preparing thin film samples.

For example, patent document 1 discloses a sample milling apparatus operating to cover a part of a sample with a shield plate and to mill a cross section of the sample by cutting out those portions of the sample which are not covered with the shield plate by the use of an ion beam.

### Citation List

### Patent Documents

Patent document 1: JP-A-2019-160575

In a sample milling apparatus using a shield plate, the shielding surface of the shield plate irradiated with the ion beam is preferably smooth. However, the irradiation with the ion beam etches not only the sample but also the shield plate, resulting in unevenness on the shielding surface. Consequently, it is impossible to reuse the shield plate several times and the shield plate having the uneven shielding surface needs to be replaced.

In view of the foregoing problem, it is conceivable to use a metallic tape around a base plate. The tape is wound around the base plate to fabricate a shield plate such that the tape forms a shielding surface. Consequently, the shield plate can be renewed by replacing the tape already wound around the base plate with a new roll of tape.

As described above, it is desirable that the shielding surface be flat and smooth. However, it is difficult to attach tape on the base plate with no creases.

### SUMMARY OF THE INVENTION

One aspect of the shield plate fabrication apparatus associated with the present invention is for use to fabricate a shield plate of a sample milling apparatus operative to mill a sample by shielding a part of the sample with the shield plate and irradiating the sample with a charged particle beam. The apparatus comprises: a base plate holding shaft for rotatably holding a base plate and winding tape around the base plate; and a tension mechanism for applying tension to the tape while it is being wound around the base plate.

With this apparatus for fabricating the shield plate, tape can be wound around the base plate while applying tension to the tape. This makes it possible to attach the tape to the base plate with no creases. Accordingly, with this fabrication apparatus, the shield plate can be fabricated easily.

One aspect of the method associated with the present invention for fabricating a shield plate is for use to fabricate the shield plate of a sample milling apparatus for milling a sample by shielding a part of the sample with the shield plate and irradiating the sample with a charged particle beam and comprises the steps of: mounting a base plate to a base plate holding shaft that rotatably holds the base plate; laying tape between the base plate held to the base plate holding shaft and a tension mechanism; and winding the tape around the base plate by rotating the base plate holding shaft while applying tension to the tape by the tension mechanism.

In this method of fabricating a shield plate, the tape can be wound around the base plate while applying tension to the tape and so the tape can be attached to the base plate without creases. Therefore, this method permits easy fabrication of the shield plate.

### BRIEF DESCRIPTION OF THE DRAWINGS

FIG. 1 is a schematic, semi-transparent perspective view, partly in pictorial representation, illustrating the manner in which a shield plate fabrication apparatus associated with a first embodiment of the present invention is held and manipulated by an operator's hands.
FIG. 2 is a schematic, semi-transparent perspective view of the shield plate fabrication apparatus of FIG. 1.
FIG. 3 is a partially cut-away perspective view of a base plate holding shaft.
FIG. 4 is a semi-transparent perspective view of a click and stop mechanism.
FIG. 5 is a perspective views of the click and stop mechanism.
FIG. 6 shows schematic views of a shaft hold-down member, illustrating its operation.
FIG. 7 is a perspective view of a tension mechanism.
FIG. 8 is a semi-transparent perspective view of the tension mechanism.
FIG. 9 is a flowchart illustrating one example of method for fabricating a shield plate.
FIGS. 10-13, 15, 16, 18, and 19 schematically illustrate a process of fabricating the shield plate.
FIGS. 14 and 17 are cross sections illustrating the process of fabricating the shield plate.
FIG. 20 is a photograph of the shield plate which has been irradiated with an electron beam after being fabricated using the fabrication apparatus of FIGS. 1 and 2.
FIG. 21 is a photograph of a shield plate which has been irradiated with an electron beam after the shield plate is fabricated involving manually winding tape therearound.
FIG. 22 is a schematic perspective view of a shield plate fabrication apparatus associated with a modified embodiment.
FIG. 23 is a schematic cross-sectional view of the shield plate fabrication apparatus of FIG. 22.
FIG. 24 is a schematic perspective view of a take-out tool for extracting the shield plate.
FIG. 25 is a schematic perspective view of the shield plate fabrication apparatus of FIGS. 22 and 23, showing the manner in which the take-out tool has been inserted in a slit.
FIGS. 26-28 are schematic cross-sectional views illustrating steps of extracting the shield plate.
FIG. 29 is a schematic, semi-transparent perspective view, partly in pictorial representation, of a shield plate fabrication apparatus associated with a second embodiment.
FIG. 30 is a schematic view, partly in cross section, of a tension mechanism incorporated in the shield plate fabrication apparatus of FIG. 29.
FIG. 31 is a view similar to FIG. 30, but showing a different operational state.
FIG. 32 is a schematic view of a sample milling apparatus associated with a third embodiment, showing the configuration of the apparatus.
FIG. 33 is a schematic cross-sectional view of the shield plate of the sample milling apparatus of FIG. 32.

### DETAILED DESCRIPTION OF THE INVENTION

The preferred embodiments of the present invention are hereinafter described in detail with reference to the drawings. It is to be understood that the embodiments set forth below are not intended to unduly restrict the content of the present invention delineated by the claims and that not all the configurations set forth hereinafter are essential constituent components of the present invention.

### 1. First Embodiment

### 1.1. Apparatus for Fabricating Shield Plate

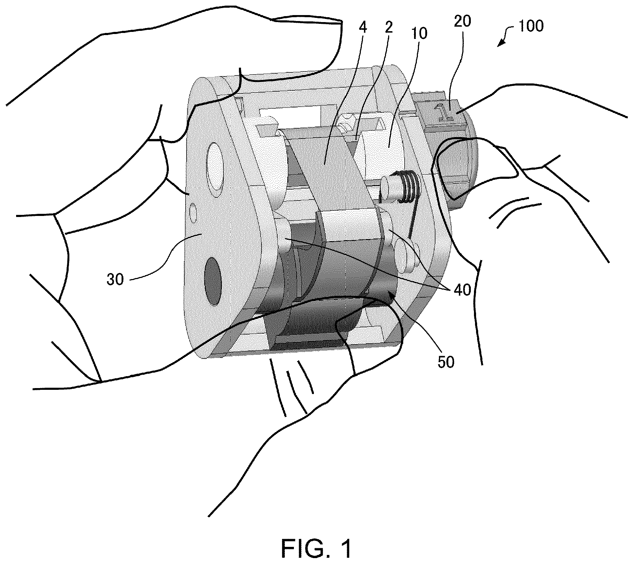

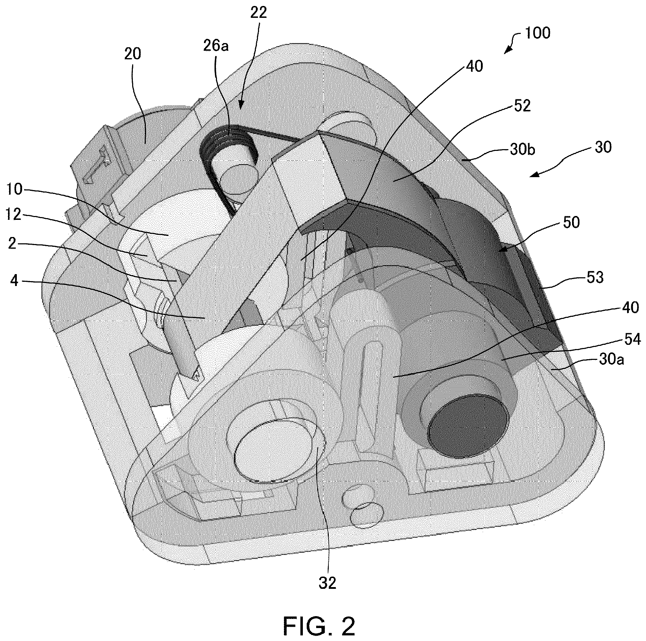

A shield plate fabrication apparatus associated with a first embodiment of the present invention is first described by referring to FIGS. 1 and 2 which are semi-transparent perspective views of the shield plate fabrication apparatus, 100, associated with the first embodiment.

The fabrication apparatus 100 is used to fabricate a shield plate used in a sample milling apparatus which in turn mills a sample by irradiating it with an ion beam while shielding a part of the sample with the shield plate. For example, the sample milling apparatus mills a cross section of the sample by cutting out the uncovered part of the sample by the ion beam while shielding a part of the sample with the shield plate. For instance, the sample milling apparatus is Cross Section Polisher (trademark registered).

A base plate 2 is a metallic plate, for example. A commercially available shield plate may also be used as the base plate 2. Tape 4 is an electrically conductive tape, for example. The tape 4 includes an electrically conductive layer and an adhesive layer, for example. One example of the electrically conductive layer is a foil of a metal such as aluminum, copper, or carbon. Another example is an electrically conductive thin film such as a graphite sheet. A glossy metal foil fabricated by rolling has a small degree of surface roughness and thus is preferably used as an electrically conductive layer. Preferably, the surface of the electrically conductive layer is a specular surface. The electrically conductive layer has a thickness of about 50 µm, for example. The adhesive layer is made of an electrically conductive adhesive and has heat resistance.

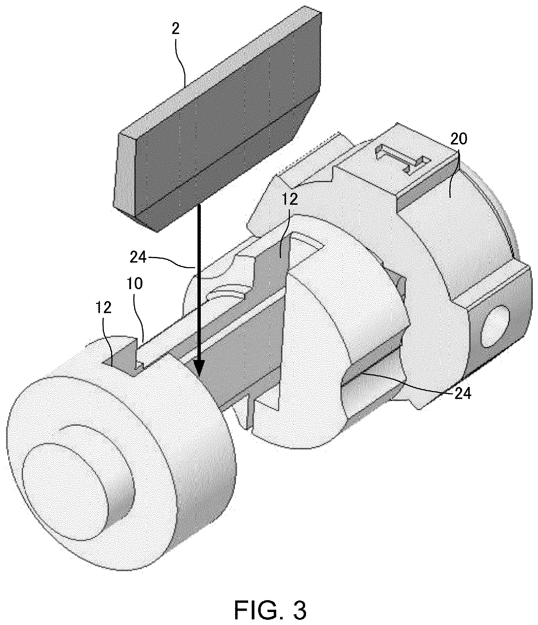

As shown in FIGS. 1 and 2, the shield plate fabrication apparatus 100 includes a base plate holding shaft 10, a knob 20, an enclosure 30, a shaft hold-down member 40, and a tension mechanism 50. The holding shaft 10 is better illustrated in FIG. 3.

The base plate holding shaft 10 holds the base plate 2 and is provided with a slit 12. The base plate 2 can be held by the holding shaft 10 by inserting the base plate 2 into the slit 12. The holding shaft 10 supports both widthwise ends of the base plate 2 and holds it so that a central portion of the base plate 2 is exposed. The tape 4 is stuck to the central portion of the base plate 2.

The base plate holding shaft 10 is connected to the knob 20. The holding shaft 10 is rotated by rotating the knob 20. Consequently, the tape 4 can be wound around the base plate 2 held to the base plate holding shaft 10.

The base plate holding shaft 10 is rotatably mounted to the enclosure 30 provided with slots 32. The holding shaft 10 is inserted in the slots 32 of the enclosure 30. More specifically, the slots 32 for receiving the holding shaft 10 are formed in the enclosure 30 and two in number. The two opposite ends of the holding shaft 10 are inserted respectively in the two slots 32.

The knob 20 is used to rotate the base plate holding shaft 10, and is attached to one end of the holding shaft 10. Numbers indicating angular positions of the shaft 10 are attached on the knob 20.

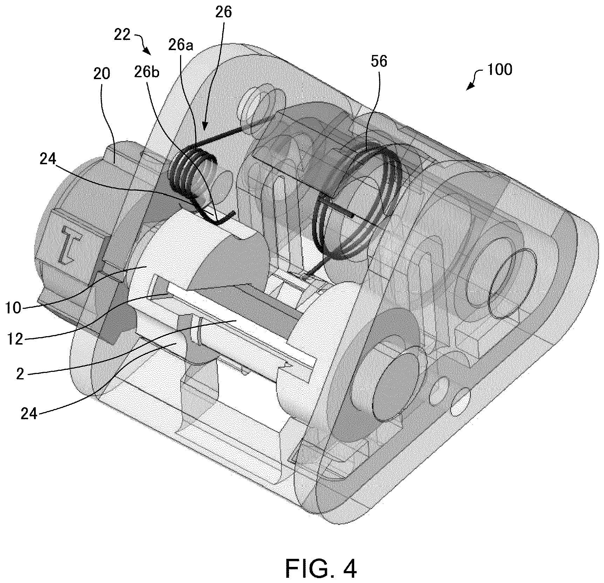

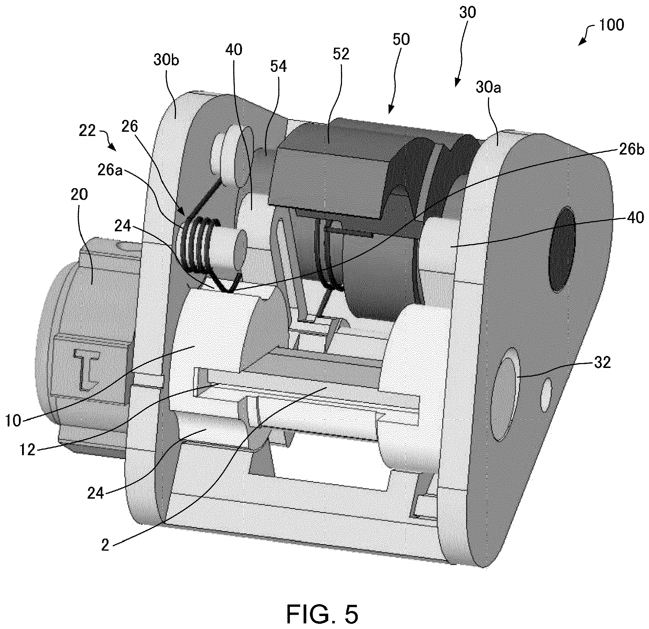

FIGS. 4 and 5 illustrate a click and stop mechanism 22 which is mounted in the knob 20 to permit stoppage of rotation of the base plate holding shaft 10 at the angular positions corresponding to the numbers attached on the knob 20. The click and stop mechanism 22 has a plurality of recesses 24 and a stopper 26, the recesses 24 being formed in the holding shaft 10.

The recesses 24 are at the angular positions corresponding to the numbers attached on the knob 20. In the illustrated example, there are three recesses 24 in the base plate holding shaft 10 in a corresponding manner to the three numbers attached on the knob 20. The stopper 26 includes a spring 26a and a convex portion 26b formed at the front end of the spring 26a. The spring 26a presses the convex portion 26b against the base plate holding shaft 10. If the holding shaft 10 is rotated to cause the convex portion 26b to fit into any one of the recesses 24, the rotation of the shaft 10 can be stopped. Therefore, the click and stop mechanism 22 can stop the rotation of the holding shaft 10 at an angular position corresponding to any one of the numbers marked on the knob 20. The spring 26a is a torsion spring, for example.

The base plate holding shaft 10, the shaft hold-down member 40, and the tension mechanism 50 are mounted in the enclosure 30. The slots 32 serving as bearings for mounting of the holding shaft 10 are formed in the enclosure 30. Each slot 32 has a longitudinal direction in which the shaft hold-down member 40 pushes the holding shaft 10.

The enclosure 30 has a first plate member 30a and a second plate member 30b which are opposite to each other. The slots 32 are formed in the first plate member 30a and the second plate member 30b, respectively. One end of the holding shaft 10 is inserted in the slot 32 formed in the first plate member 30a, while the other end of the shaft 10 is inserted in the slot 32 formed in the second plate member 30b. Similarly, one end of an arm securing shaft 54 of the tension mechanism 50 is inserted in a hole formed in the first plate member 30a, while the other end of the shaft 54 is inserted in a hole formed in the second plate member 30b. The arm securing shaft 54 is rotatably supported to the enclosure 30.

The shaft hold-down member 40 holds down the base plate holding shaft 10 such that a force opposite in direction to the tension applied to the tape 4 by the tension mechanism 50 is applied to the tape 4. The shaft hold-down member 40 comprises springs (such as U-shaped springs) and biases the base plate holding shaft 10 away from the tension mechanism 50. In the illustrated example, the shaft hold-down member 40 has two springs which hold down the two opposite ends, respectively, of the base plate holding shaft 10.

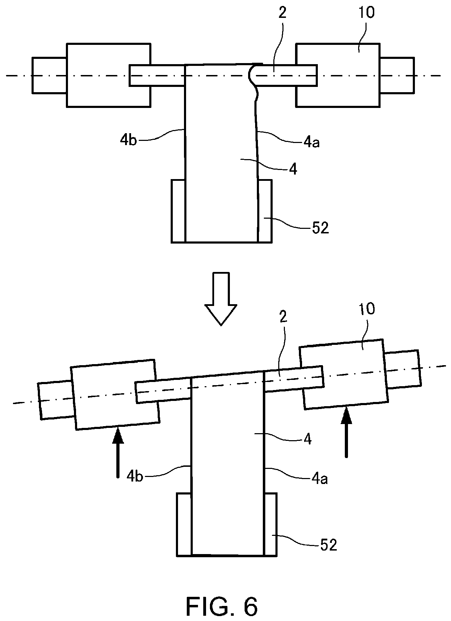

FIG. 6 illustrates the shaft hold-down member 40. As mentioned previously, the shaft hold-down member 40 holds down the base plate holding shaft 10 such that a force opposite in direction to the tension applied to the tape 4 by the tension mechanism 50 is applied to the tape 4. Since the holding shaft 10 is supported by the slots 32, the shaft 10 can be supported flexibly. Therefore, when the holding shaft 10 is rotated to wind the tape 4 around the base plate 2 as shown in FIG. 6, flexure of the tape 4 can be prevented.

As an example, where the axis of the base plate holding shaft 10 is fixed, if the tape 4 is stuck at an angle to the axis of the holding shaft 10, one side (first side 4a in the illustrated example) of two opposite sides of the tape 4 (first side 4a and second side 4b) will flex as shown in FIG. 6. Under this condition, if the tape 4 is wound around the base plate 2, creases will form on the tape 4.

In contrast, in the shield plate fabrication apparatus 100, the slots 32 can provide flexible support of the base plate holding shaft 10 while holding down the shaft 10 by the shaft hold-down member 40. This can prevent flexure of the tape 4 and so the tape 4 can be stuck to the base plate 2 without creases.

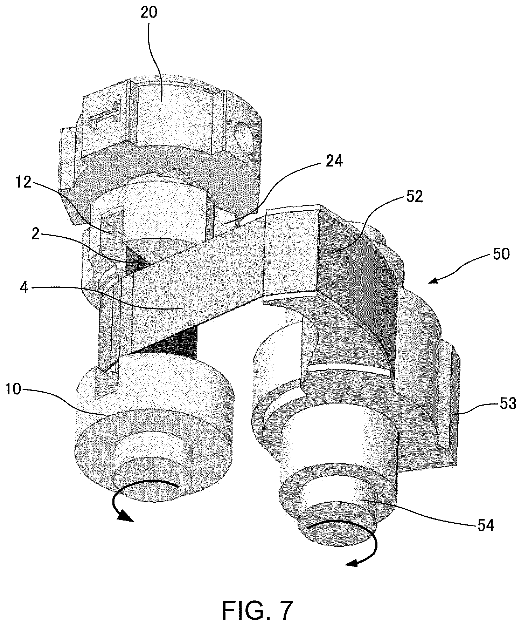

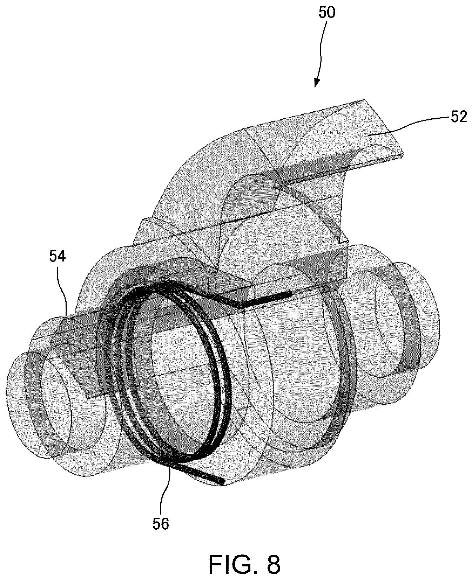

FIGS. 7 and 8 illustrate the tension mechanism 50. This mechanism 50 applies tension to the tape 4 wound around the base plate 2. As shown in these figures, the tension mechanism 50 includes an arm 52, the arm securing shaft 54, and a spring 56.

One end of the tape 4 is secured to the arm 52. The tape 4 is laid between the base plate 2 held to the base plate holding shaft 10 and the arm 52. Because one end of the tape 4 is secured to the arm 52, the tape 4 is wound around the base plate holding shaft 10 from the other end of the tape 4 by rotating the holding shaft 10. The arm 52 is rotatably secured to the arm securing shaft 54. The arm 52 is provided with a stopper 53 for limiting the range of movement of the arm 52. The arm securing shaft 54 is rotatably mounted to the enclosure 30.

The spring 56 biases the arm 52 so that the arm 52 rotates in a direction opposite to the direction of rotation of the base plate holding shaft 10 when the tape 4 is wound. Consequently, tension can be applied to the tape 4. The spring 56 is a torsion spring, for example.

### 1.2. Method of Fabricating Shield Plate

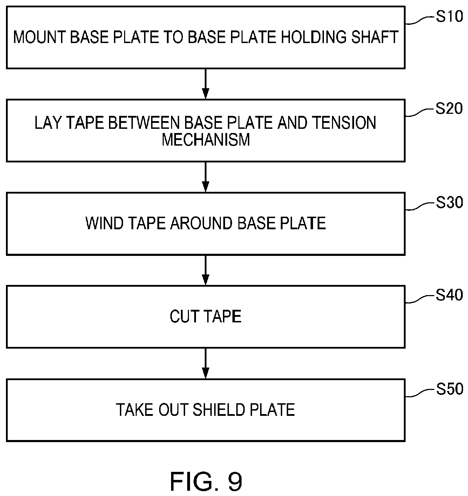

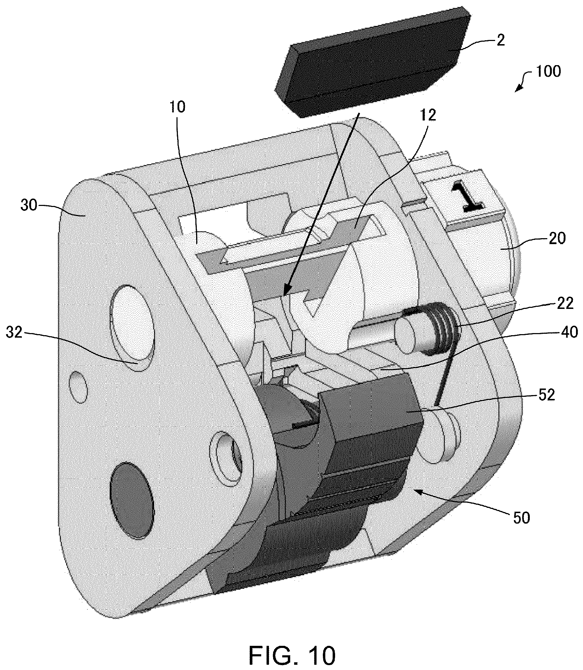

A method of fabricating a shield plate by the use of the shield plate fabrication apparatus 100 is next described. FIG. 9 is a flowchart illustrating one example of the shield plate fabrication method using the fabrication apparatus 100. FIGS. 10-19 schematically illustrate a fabrication process for the shield plate.

### (1) Mounting of Base Plate (S10)

First, as illustrated in FIG. 10, the base plate 2 is mounted to the base plate holding shaft 10. In particular, the knob 20 is first rotated such that it is set to number "1". In response, the shaft 10 rotates such that the slit 12 formed in the shaft 10 is so placed that it is not shadowed either by the enclosure 30 or by the arm 52. Then, the base plate 2 is inserted into the slit 12, whereby the base plate 2 can be mounted to the base plate holding shaft 10.

### (2) Laying of Tape (S20)

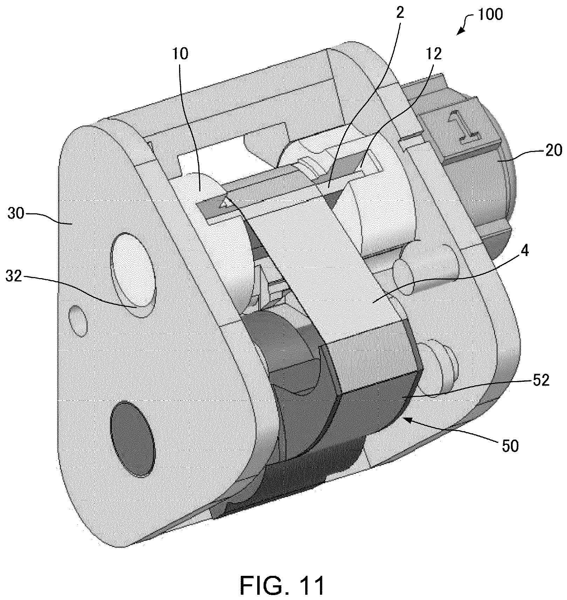

Then, the tape 4 is laid between the base plate 2 held to the base plate holding shaft 10 and the arm 52 of the tension mechanism 50 as shown in FIG. 11. In particular, one end of the tape 4 is stuck to the arm 52, and the other end of the tape 4 is stuck to the base plate holding shaft 10 and to the base plate 2. Since the tape 4 has the adhesive layer, the tape 4 can be stuck to all of the arm 52, base plate holding shaft 10, and base plate 2. In this way, the tape 4 can be laid between the base plate 2 held to the holding shaft 10 and the arm 52 of the tension mechanism 50.

In the foregoing example, the other end of the tape 4 is stuck to both the base plate holding shaft 10 and the base plate 2. Alternatively, the other end of the tape 4 may be stuck to only the base plate 2. Furthermore, the other end of the tape 4 may be inserted into the slit 12. In addition, the tape 4 may be stuck to the base plate 2 by rotating the base plate holding shaft 10 after sticking the other end of the tape 4 to the holding shaft 10. (3) Winding of Tape around Base Plate (S30).

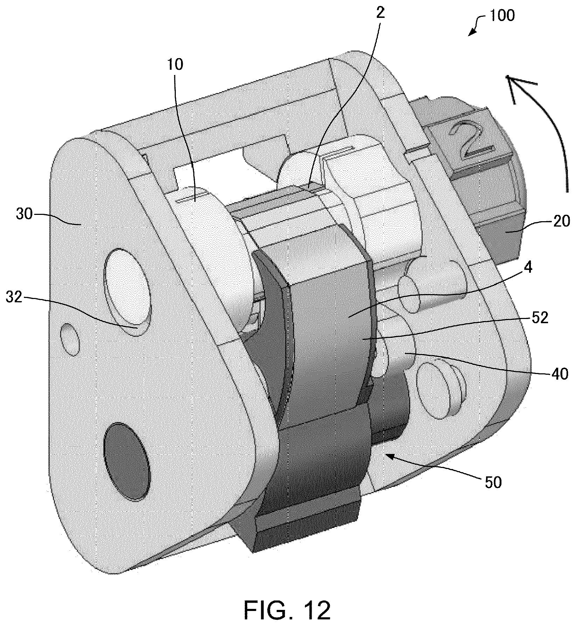

Then, as shown in FIG. 12, the tape 4 is wound around the base plate 2 by rotating the base plate holding shaft 10. In particular, the knob 20 is rotated to vary the set number for the knob 20 from "1" to "2". As a result, the holding shaft 10 rotates through a given angle, so that the tape 4 is wound around the base plate 2.

At this time, tension is applied to the tape 4 by the tension mechanism 50. In particular, the spring 56 urges the arm 52 to rotate in a direction opposite to the direction of rotation of the base plate holding shaft 10 when the tape 4 is wound. Therefore, when the tape 4 is wound around the base plate 2, tension is applied to the tape 4 and the tape 4 can be kept in tension. When the base plate holding shaft 10 is rotated, a finger may be put on the arm securing shaft 54 and a force may be applied to the arm 52. This can increase the tension applied to the tape 4.

The shaft hold-down member 40 holds down the base plate holding shaft 10 so that a force opposite in direction to the tension applied to the tape 4 by the tension mechanism 50 is applied to the tape 4. The holding shaft 10 is inserted in the slots 32 and thus can move flexibly. This can prevent flexure of the tape 4. In this way, with the shield plate fabrication apparatus 100, the tape 4 can be wound around the base plate 2 while applying tension to the tape 4 and, therefore, the tape 4 can be stuck to the base plate 2 without creases.

### (4) Cutting of Tape (S40)

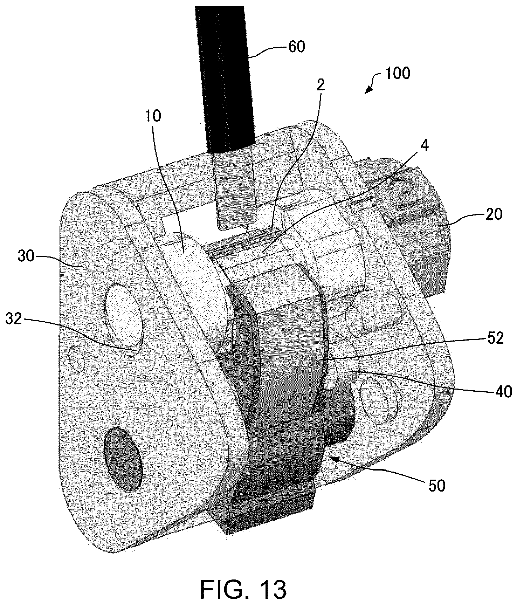

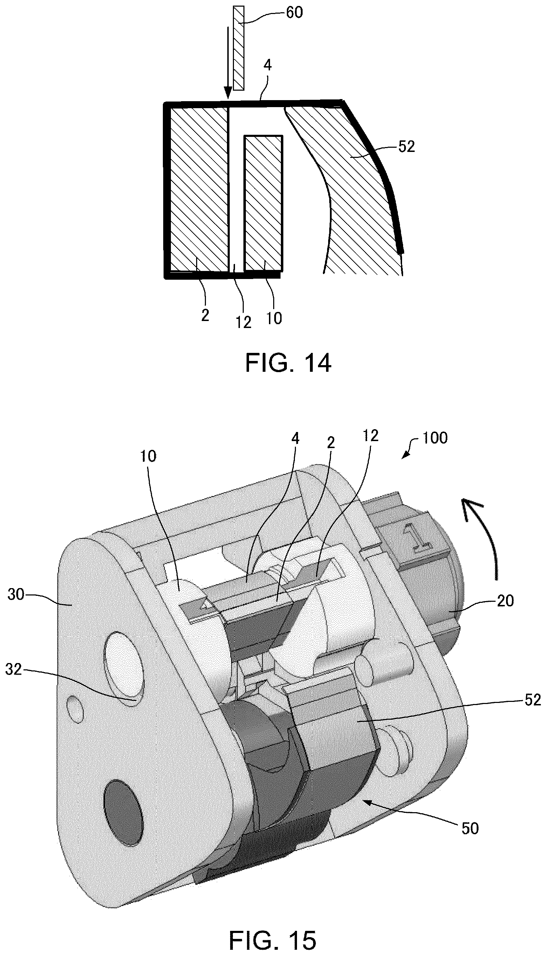

Then, the tape 4 is cut. In particular, a tape cutting tool 60 is inserted along the base plate 2 into the slit 12 as shown in FIGS. 13 and 14, whereby the tape 4 can be cut. For example, the tape cutting tool 60 is a cutter knife that is narrower in width than the slit 12.

"1". Then, as shown in FIG. 15, the knob 20 is rotated to vary the set number from "2" to

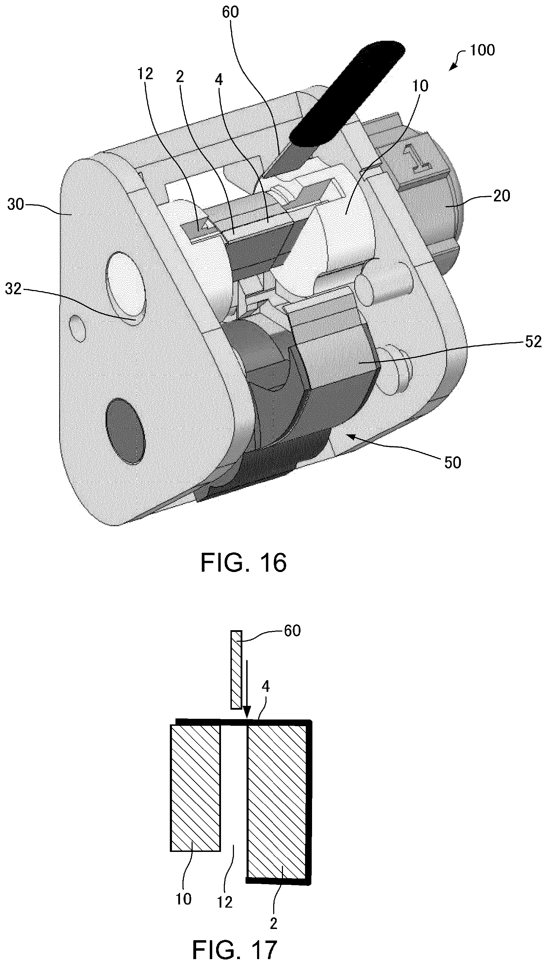

Then, as shown in FIGS. 16 and 17, the tape cutting tool 60 is inserted along the base plate 2 into the slit 12. Consequently, the tape 4 can be cut. In this way, by inserting the tape cutting tool 60 along the base plate 2 into the slit 12, a force is applied to the tape 4 already wound around the edge of the base plate 2 and so the tape 4 can be brought into intimate contact with the base plate 2. In consequence, the tape 4 can be stuck up to its end to the base plate 2 without creases. In this way, the shield plate 6 can be fabricated.

### (5) Taking Out of Shield Plate (S50)

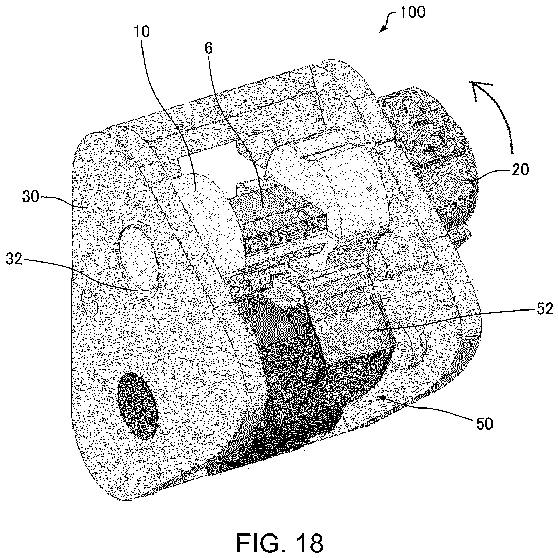

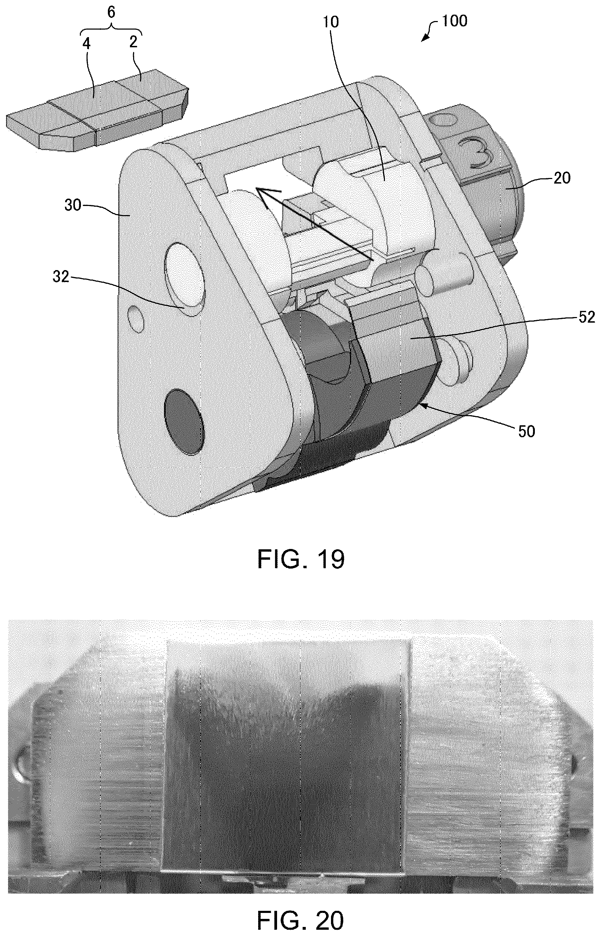

Then, as shown in FIG. 18, the shield plate 6 is taken out from the base plate holding shaft 10. In particular, the knob 20 is rotated to vary the set number for the knob 20 from "1" to "3". Consequently, as shown in FIG. 19, the shield plate 6 can be taken out through the opening of the slit 12 in the base plate holding shaft 10. Because of the processing steps described thus far, the shield plate 6 can be fabricated.

### 1.3. Advantageous Effects

The shield plate fabrication apparatus 100 is used to fabricate the shield plate 6 of the sample milling apparatus and includes: the base plate holding shaft 10 for rotatably holding the base plate 2 and winding the tape 4 around the base plate 2; and the tension mechanism 50 for applying tension to the tape 4 while it is being wound around the base plate 2. Therefore, in the shield plate fabrication apparatus 100, the tape 4 can be wound around the base plate 2 while applying tension to the tape 4. Consequently, in the shield plate fabrication apparatus 100, the tape 4 can be stuck to the base plate 2 without creases. Hence, with the shield plate fabrication apparatus 100, the shield plate 6 can be fabricated with ease.

In the shield plate fabrication apparatus 100, the tension mechanism 50 includes the arm 52 to which one end of the tape 4 is secured, the arm securing shaft 54 to which the arm 52 is rotatably fixed, and the spring 56 for biasing the arm 52 in a direction opposite to the direction of rotation of the base plate holding shaft 10 when the tape 4 is wound. Furthermore, in the shield plate fabrication apparatus 100, the tape 4 is wound around the base plate 2 from around the other end of the tape 4 by rotating the base plate holding shaft 10. In this way, the tension mechanism 50 can apply tension to the tape 4 by biasing the arm 52 in a direction opposite to the direction of rotation of the base plate holding shaft 10 when the spring 56 winds the tape 4.

The shield plate fabrication apparatus 100 includes the enclosure 30 provided with the slots 32 receiving the base plate holding shaft 10 and the shaft hold-down member 40 for holding down the holding shaft 10 such that a force opposite in direction to the tension applied to the tape 4 by the tension mechanism 50 is applied to the tape 4. Therefore, as described above, when the tape 4 is wound around the base plate 2, flexure of the tape 4 can be prevented. Consequently, the tape 4 can be stuck to the base plate 2 with no creases.

The shield plate fabrication apparatus 100 includes the knob 20 for rotating the base plate holding shaft 10 and so this shaft 10 can be easily rotated manually.

The method of fabricating the shield plate 6 using the shield plate fabrication apparatus 100 involves the steps of: mounting the base plate 2 to the base plate holding shaft 10 that rotatably holds the base plate 2; laying the tape 4 between the base plate 2 held to the base plate holding shaft 10 and the tension mechanism 50; and winding the tape 4 around the base plate 2 by rotating the holding shaft 10 while applying tension to the tape 4 by the tension mechanism 50. In this method of fabricating the shield plate 6 using the shield plate fabrication apparatus 100, the tape 4 is wound around the base plate 2 while applying tension to the tape 4 by the tension mechanism 50. Therefore, the tape 4 can be stuck to the base plate 2 without creases. Consequently, with this method of fabricating the shield plate 6 using the shield plate fabrication apparatus 100, it is easy to fabricate the shield plate 6.

In the method of fabricating the shield plate 6 by the use of the shield plate fabrication apparatus 100, the base plate holding shaft 10 is inserted in the slots 32 formed in the enclosure 30. In the step of winding the tape 4 around the base plate 2, the shaft hold-down member 40 holds down the base plate holding shaft 10 such that a force opposite in direction to the tension applied to the tape 4 by the tension mechanism 50 is applied to the tape 4. Therefore, when the tape 4 is wound around the base plate 2, flexing of the tape 4 can be prevented. Accordingly, the tape 4 can be stuck to the base plate 2 with no creases. In this way, with the method of fabricating the shield plate 6 by the use of the shield plate fabrication apparatus 100, it is easy to stick the tape 4 to the base plate 2 without creases. Hence, the shield plate 6 can be fabricated easily.

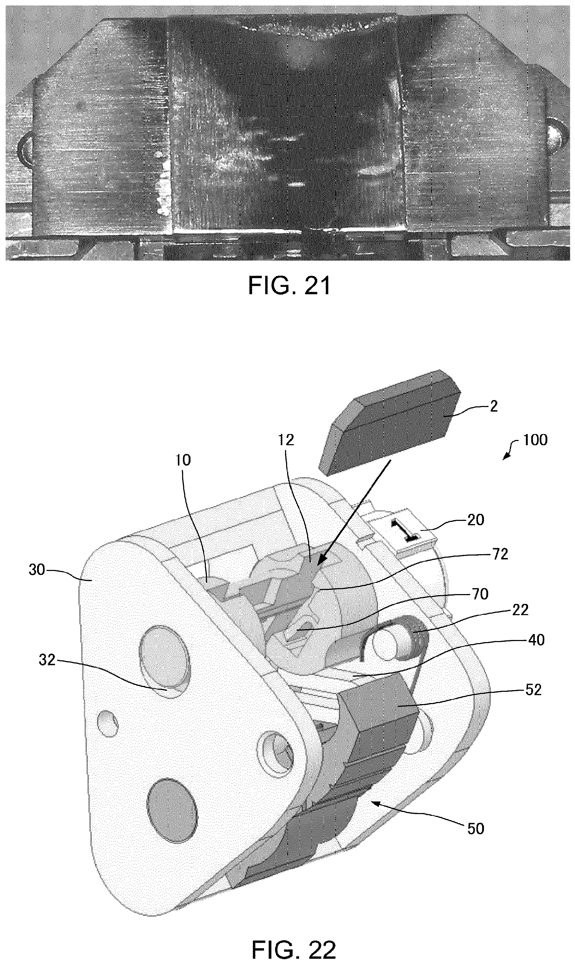

FIG. 20 is a photograph of the shield plate which has been irradiated with an ion beam after being fabricated using the shield plate fabrication apparatus 100. FIG. 21 is a photograph of a shield plate which has been irradiated with an ion beam after being fabricated by manually winding tape around the base plate. The used tape was aluminum tape. Each irradiation operation of the shield plate with the ion beam was performed at an acceleration voltage of 6 kV for 8 hours.

As shown in FIG. 21, where tape is wound around the base plate manually, the tape is creased, and the creases will be selectively etched. In contrast, for the shield plate fabricated using the shield plate fabrication apparatus 100, the tape has no creases and so the shielding surface of the tape will be etched uniformly. Consequently, the shield plate fabricated using the shield plate fabrication apparatus 100 has a long life.

### 1.4. Modifications

### 1.4.1. Shield Plate Fabrication Apparatus

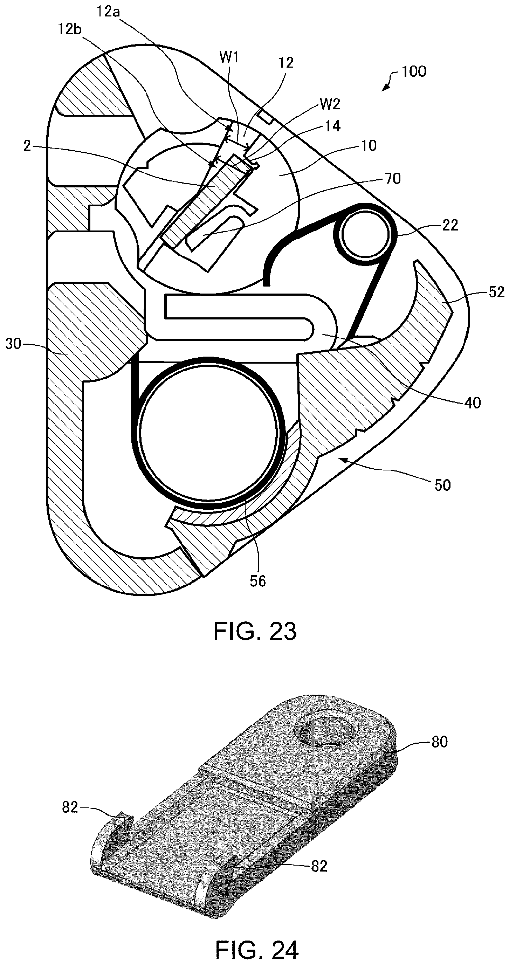

FIG. 22 is a schematic perspective view of a shield plate fabrication apparatus, 100, associated with one modification. FIG. 23 is a schematic cross-sectional view of this fabrication apparatus 100 of FIG. 22. Note that those members of this shield plate fabrication apparatus 100 which are similar in function to their counterparts of the foregoing shield plate fabrication apparatus 100 of FIGS. 1 and 2 are indicated by the same reference numerals as in these FIGS. 1 and 2 and a detailed description thereof is omitted below.

As shown in FIGS. 22 and 23, the shield plate fabrication apparatus 100 associated with the modification includes a base plate securing spring 70 for pushing the base plate 2 against the base plate holding shaft 10. The base plate securing spring 70 is mounted in the slit 12 and presses, within the slit 12, the base plate 2 against a surface defining the slit 12 of the base plate holding shaft 10. This ensures that the base plate 2 is secured to the base plate holding shaft 10.

The inside space of the slit 12 has a first space 12a on the opening side of the slit 12 and a second space 12b on the bottom side of the slit 12 as shown in FIG. 23. The width W2 of the second space 12b is greater than the width W1 of the first space 12a. Therefore, a hook (step) 14 is formed between the first space 12a and the second space 12b. The base plate 2 inserted in the slit 12 is pushed by the base place securing spring 70 and becomes caught by the hook 14 of the base plate holding shaft 10. Consequently, the base plate 2 can be secured reliably to the holding shaft 10.

### 1.4.2. Method of Fabricating Shield Plate

The shield plate fabrication method using the shield plate fabrication apparatus 100 of FIGS. 22 and 23 is similar to the foregoing fabrication method except for both the step S10 of mounting the base plate 2 to the base plate holding shaft 10 and the step S50 of taking out the shield plate 6 as illustrated in FIG. 9. In the following description, the differences with the foregoing fabrication method are set forth, and a description of similarities is omitted.

First, the step S10 of mounting the base plate 2 is described. As shown in FIG. 22, the base plate 2 is mounted to the base plate holding shaft 10 of the shield plate fabrication apparatus 100. In particular, the knob 20 is rotated to vary the set number for the knob 20 to "1". Then, the base plate 2 is inserted into the slit 12.

At this time, the base plate 2 is inserted from its front end portion into the slit 12. With the sample milling apparatus, etching progresses along the edge on a front end portion of the shield plate 6. Therefore, the front end portion of the shield plate 6 can be protected by inserting the base plate 2 from the front end portion of the base plate 2 which will become the front end portion of the shield plate 6.

When the base plate 2 is inserted into the slit 12, the base plate 2 is pressed against the base plate holding shaft 10 by the base plate securing spring 70 and becomes caught by the hook 14. This makes it possible to mount the base plate 2 to the holding shaft 10.

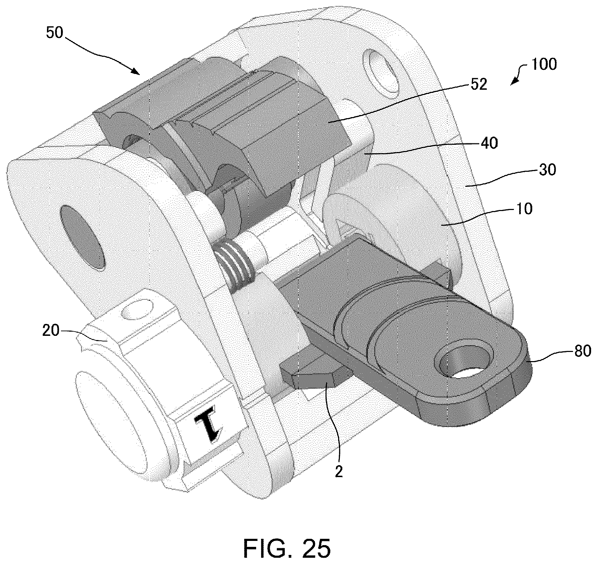

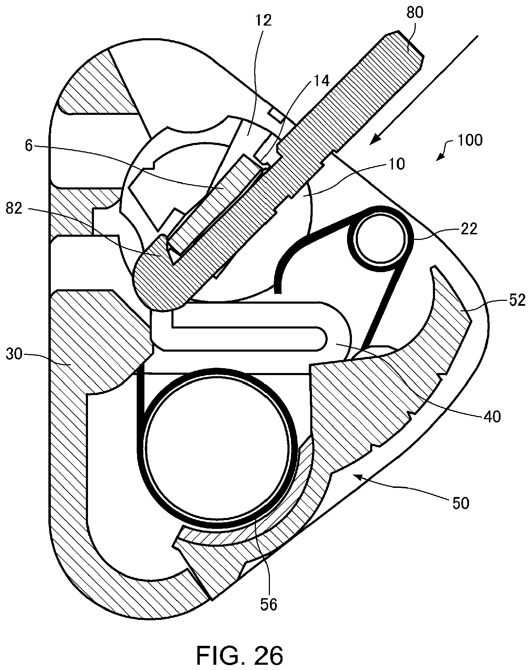

The step S50 of taking out the shield plate 6 is next described. FIG. 24 is a schematic perspective view of a take-out tool 80 for taking out the shield plate 6. FIG. 25 schematically illustrates a condition in which the take-out tool 80 has been inserted in the slit 12. FIGS. 26-28 are schematic cross-sectional views illustrating the step of taking out the shield plate 6 from the base plate holding shaft 10 by the use of the take-out tool 80.

The take-out tool 80 is used to take out the shield plate 6 from the slit 12 in the base plate holding shaft 10. As shown in FIG. 24, the take-out tool 80 has claws 82 by which the shield plate 6 is to be caught.

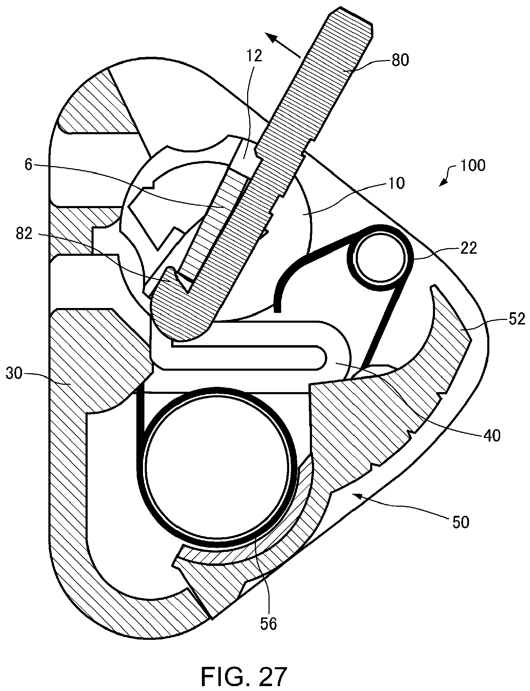

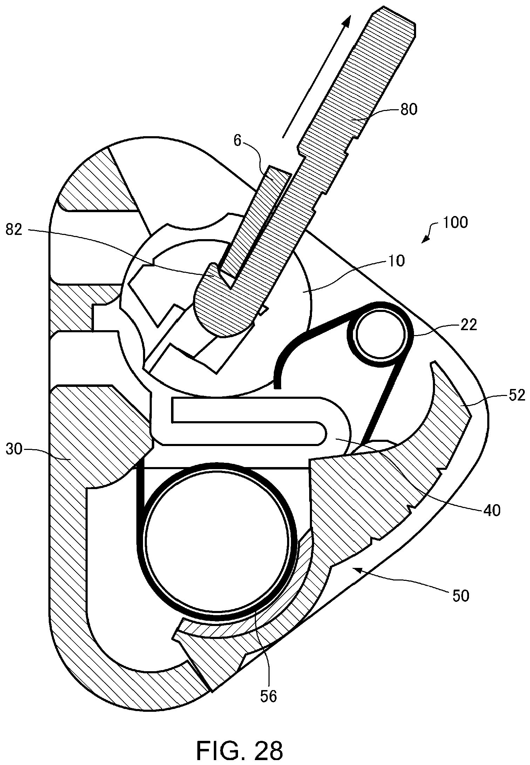

In the step of taking out the shield plate 6, the take-out tool 80 is inserted into the slit 12 as shown in FIGS. 25 and 26. At this time, as shown in FIG. 26, the claws 82 of the take-out tool 80 are caught by the shield plate 6 within the slit 12. Then, as shown in FIG. 27, the shield plate 6 is pushed by the take-out tool 80 and tilted. This disengages the shield plate 6 from the hook 14. Then, as shown in FIG. 28, the take-out tool 80 is pulled out from the slit 12. Consequently, the shield plate 6 can be taken out from inside the slit 12.

In the shield plate fabrication method using the shield plate fabrication apparatus 100 associated with the modification, the shield plate 6 is taken out using the take-out tool 80 and so it can be prevented that the surface of the tape 4 is fouled or damaged.

### 2. Second Embodiment

### 2.1. Shield Plate Fabrication Apparatus

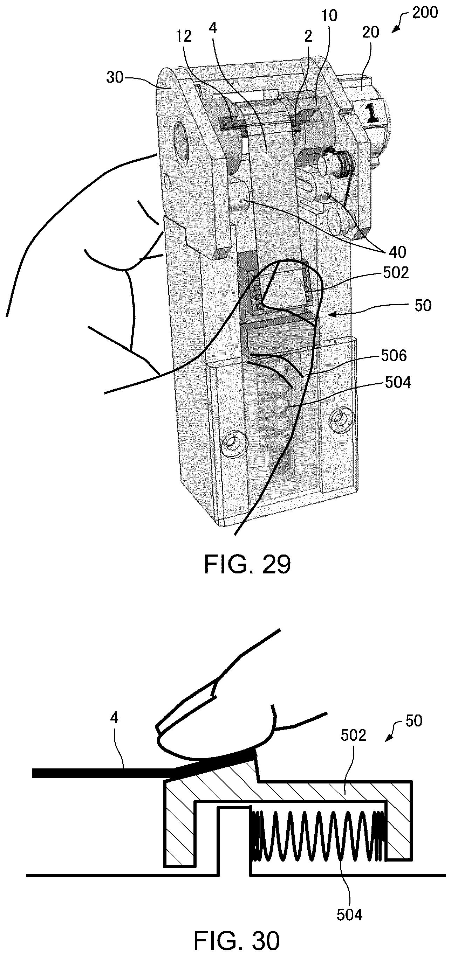

A shield plate fabrication apparatus associated with a second embodiment is next described by referring to FIG. 29, which is a schematic perspective view of this shield plate fabrication apparatus, 200, associated with the second embodiment. Those members of the fabrication apparatus 200 which are similar in function to their counterparts of the shield plate fabrication apparatus 100 associated with the first embodiment are hereinafter indicated by the same reference numerals as in the foregoing figures and a detailed description thereof is omitted below.

The shield plate fabrication apparatus 200 is similar to the foregoing shield plate fabrication apparatus 100 except for the configuration of the tension mechanism 50. In the following description, only the differences with the above-described shield plate fabrication apparatus 100 are described; a description of similarities is omitted.

FIG. 30 illustrates the tension mechanism 50 of the shield plate fabrication apparatus 200. As shown in FIGS. 29 and 30, the tension mechanism 50 includes a slider (sliding member) 502, a spring 504, and a guide member 506.

The slider 502 slides along the guide member 506 mounted to the enclosure 30 as shown in FIG. 29. The guide member 506 extends vertically, for example, to the base plate holding shaft 10. The slider 502 and the guide member 506 together constitute a linear guide. One end of the tape 4 is stuck to the slider 502.

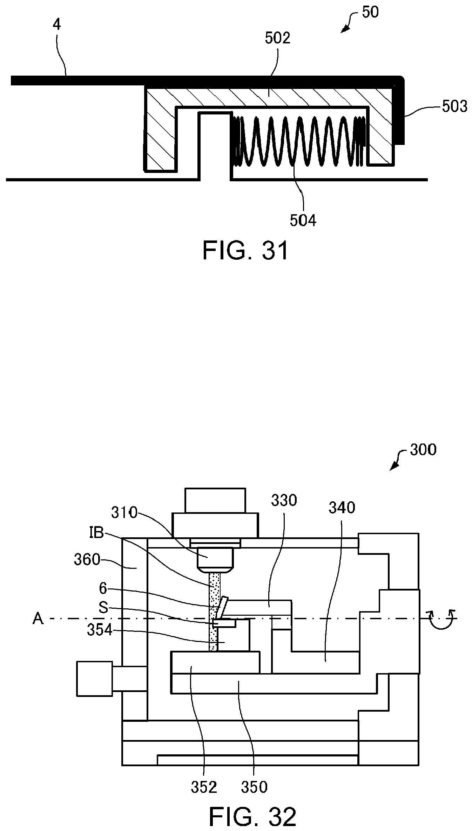

As shown in FIG. 31, the tape 4 may be stuck down to a rear end portion 503 of the slider 502, in which case the tape 4 can be bent over and prevented from peeling due to tension. A securing member (not shown) for securing the tape 4 may be mounted on the slider 502. One example of the securing member is a clip for gripping the tape 4 therein. By securing the tape 4 with the securing member, the tape 4 can be secured to the slider 502 more certainly as compared with the case where the tape 4 is secured to the slider 502 only with the adhesive force of the tape 4.

The spring 504 is connected to the slider 502 and biases the slider 502 such that tension is applied to the tape 4 which is laid between the base plate 2 and the slider 502, the base plate 2 being held to the base plate holding shaft 10. One example of the spring 504 is a compression spring. Another example is a coil spring. In the shield plate fabrication apparatus 200, a generally used coil spring can be used as the spring 504 for applying tension to the tape 4.

### 2.2. Method of Fabricating Shield Plate

A method of fabricating a shield plate by the use of the shield plate fabrication apparatus 200 is next described. The process flow of this fabrication method using the shield plate fabrication apparatus 200 is similar to the process flow of the shield plate fabrication method using the shield plate fabrication apparatus 100 already described in connection with the flowchart of FIG. 9. Only the differences with the fabrication method using the shield plate fabrication apparatus 100 are described; a description of similarities is omitted.

### (1) Mounting of Base Plate (S10)

First, the base plate 2 is mounted to the base plate holding shaft 10 of the shield plate fabrication apparatus 200.

### (2) Laying Tape (S20)

Then, as shown in FIG. 29, the tape 4 is laid between the base plate 2 and the slider 502, the base plate 2 being held to the base plate holding shaft 10. In particular, one end of the tape 4 is stuck to the slider 502, while the other end of the tape 4 is stuck to the holding shaft 10 and to the base plate 2. Since the tape 4 has the adhesive layer, it is possible to stick the tape 4 to the slider 502, the base plate holding shaft 10, and the base plate 2. Alternatively, the other end of the tape 4 may be secured to the slider 502 with a securing member such as a clip in a manner not illustrated.

### (3) Winding of Tape around Base Plate (S30)

Then, the base plate holding shaft 10 is rotated to wind the tape 4 around the base plate 2. In particular, the knob 20 is rotated to vary the set number for the knob 20 from "1" to "2". As a result, the base plate holding shaft 10 rotates through a given angle and the tape 4 is wound around the base plate 2.

At this time, tension is applied to the tape 4 by the tension mechanism 50. In particular, because the tape 4 is wound around the base plate 2, the spring 504 is compressed and generates a reaction force, thus applying tension to the tape 4. As the tape 4 is wound more around the base plate 2, the tension applied from the spring 504 to the tape 4 increases.

When the base plate holding shaft 10 is rotated, the tape 4 on the slider 502 may be held down by a finger to prevent the tape 4 from peeling off the slider 502.

The shaft hold-down member 40 holds down the base plate holding shaft 10 so that a force opposite in direction to the tension applied from the tension mechanism 50 to the tape 4 is applied to the tape 4. The holding shaft 10 is inserted in the slots 32 and can move flexibly. Consequently, flexing of the tape 4 can be prevented.

### (4) Cutting of Tape (S40)

Then, the tape 4 is cut by the use of the tape cutting tool 60. Before the cutting of the tape 4, it may be peeled off from the slider 502 by releasing that finger from the tape 4 which has held down it.

### (5) Taking Out of Shield Plate (S50)

Then, the shield plate 6 is taken out from the base plate holding shaft 10. For example, the shield plate 6 may be taken out using the take-out tool 80 shown in FIG. 24. Because of the processing steps described so far, the shield plate 6 can be fabricated.

### 2.3. Advantageous Effects

In the shield plate fabrication apparatus 200, the tension mechanism 50 includes the slider 502 to which one end of the tape 4 is secured and the spring 504 connected to the slider 502 and applying tension to the tape 4. The tape 4 is wound around the base plate 2 from its other end side by rotating the base plate holding shaft 10. Consequently, the fabrication apparatus 200 can stick the tape 4 to the base plate 2 without creases in the same way as the shield plate fabrication apparatus 100.

### 3. Third Embodiment

### 3.1. Sample Milling Apparatus

A sample milling apparatus associated with a third embodiment is next described by referring to FIG. 32, which shows the configuration of this sample milling apparatus, 300. The sample milling apparatus 300 shields a part of the sample S with the shield plate 6 and irradiates the sample S with an ion beam IB, thus milling the sample S. The sample milling apparatus 300 can fabricate a cross-sectional sample, for example, for use in scanning electron microscopy. The sample milling apparatus 300 may also be an apparatus for irradiating a sample with a charged particle beam other than an ion beam, such as an electron beam.

As shown in FIG. 32, the sample milling apparatus 300 includes the shield plate 6. The milling apparatus 300 further includes an ion source 310, a shield plate holder 330, a support member 340, a sample stage assembly 350, and a vacuum chamber 360.

The ion source 310 is mounted at the top of the vacuum chamber 360 and emits the ion beam IB at the sample S. For example, the ion source 310 is an ion gun which releases the ion beam IB by accelerating ions at a given acceleration voltage. An Ar ion beam can be used as the ion beam IB, for example.

The shield plate 6 is disposed on the sample S and covers a part of the top surface Sa of the sample S. A cross section can be formed along a boundary between the irradiated area etched by the ion beam IB and the non-irradiated area which is shielded by the shield plate 6 and thus is not etched, by placing the shield plate 6 on the sample S and emitting the ion beam IB.

The shield plate holder 330 holds the shield plate 6, and the support member 340 supports the shield plate holder 330. The support member 340 is equipped with a shield plate position adjusting mechanism for adjusting the position of the shield plate 6.

The sample stage assembly 350 is provided with a sample position adjusting mechanism 352 on which a sample holder 354 for holding the sample S is mounted. The sample position adjusting mechanism 352 allows for positional adjustment of the sample S.

The sample stage assembly 350 has a rotational mechanism capable of rotating both the sample S held to the sample holder 354 and the shield plate 6 about an axis of rotation A perpendicular to the optical axis of the ion beam IB. The rotational mechanism is driven by an electric motor, for example. In the sample milling apparatus 300, the ion beam IB can be directed at the sample S while swinging the sample S and the shield plate 6 about the axis of rotation (swing axis) A by means of the rotational mechanism.

In the sample milling apparatus 300, the shield plate position adjusting mechanism and the sample position adjusting mechanism 352 cooperate to permit adjustments of (i) the positional relationship between the shield plate 6 and the sample S, (ii) the positional relationship between the sample S and the ion source 310, and (iii) the positional relationship between the shield plate 6 and the ion source 310.

The sample S is received in the vacuum chamber 360 whose interior can be placed in a vacuum state by a vacuum pump (not shown). Inside the chamber 360, the sample S is irradiated with the ion beam IB.

The sample milling apparatus 300 may have a camera (not shown) for checking the positions of the shield plate 6 and the sample S, as well as a camera (not shown) for checking the condition of the milling of the sample S.

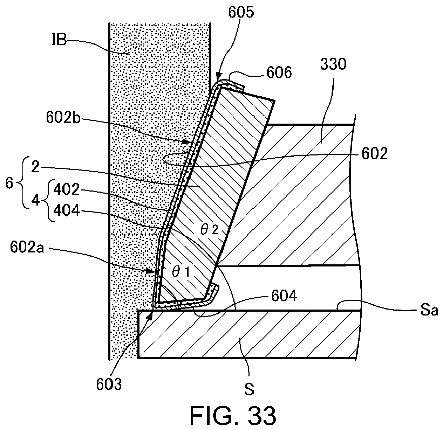

FIG. 33 is a schematic cross-sectional view of the shield plate 6 of the sample milling apparatus 300. The shield plate 6 is placed on the top surface Sa of the sample S. The ion beam IB is directed perpendicularly to the axis of rotation (swing axis) A of the sample S and of the shield plate 6. The axis A passes through the boundary between the top surface Sa of the sample S and the shield plate 6, the top surface Sa being parallel to the axis A. With the sample milling apparatus 300, it is possible to form a cross section vertical to the top surface Sa of the sample S which is parallel to the axis A by irradiating the top surface Sa with the ion beam IB.

The shield plate 6 includes a shielding surface 602, a bottom surface 604, and a top surface 606. The shielding surface 602 is hit by the ion beam IB and has a first tilted surface 602a and a second tilted surface 602b. The first tilted surface 602a is connected to the bottom surface 604. The first tilted surface 602a and the bottom surface 604 together form a lower edge 603. The first tilted surface 602a is not vertical but is slightly tilted relative to the normal to the top surface Sa of the sample S. The first tilted surface 602a and the top surface Sa of the sample S together form an acute angle of θ1. For example, 85° < θ1 < 90°. Because the first tilted surface 602a is tilted relative to the normal to the top surface Sa of the sample S, if the illumination angle of the ion beam IB deviates, the shield plate 6 can be prevented from creating a shadow on the top surface Sa of the sample S.

The second tilted surface 602b is connected to the first tilted surface 602a and to the top surface 606. The second tilted surface 602b and the top surface 606 together form an upper edge 605. The second tilted surface 602b is tilted at a smaller angle relative to the top surface Sa of the sample S than the first tilted surface 602a. The second tilted surface 602b and the top surface Sa of the sample S together form an acute angle of θ2. For example, 65° < θ2 < θ1.

Because the shielding surface 602 has the second tilted surface 602b, increases in size of the shield plate 6 are prevented, and the upper edge 605 formed by both the shielding surface 602 and the top surface 606 can be placed at a position where the strength of the ion beam IB is low. For example, if the shielding surface 602 consists of a single tilted surface, the height of the shield plate 6 must be increased in order to place the upper edge 605 at such a position where the strength of the ion beam IB is low. This will reduce the distance between the shield plate 6 and the ion source 310.

In contrast, the shielding surface 602 has the second tilted surface 602b which has a smaller tilt angle than the first tilted surface 602a. Therefore, the upper edge 605 can be placed at a position where the strength of the ion beam IB is low while preventing the height of the shield plate 6 from increasing. Hence, the upper edge 605 can be placed at a position where the strength of the ion beam IB is low while appropriately maintaining the distance between the shield plate 6 and the ion source 310.

The bottom surface 604 faces the top surface Sa of the sample S and is connected to the shielding surface 602. The shielding surface 602 and the bottom surface 604 together form the lower edge 603. In the illustrated example, the first tilted surface 602a is connected to the bottom surface 604, thus forming the lower edge 603. The lower edge 603 defines a boundary between an irradiated area etched by the ion beam IB and a non-irradiated area which is shielded by the shield plate 6 and thus is not etched by the ion beam IB.

Since the bottom surface 604 is tilted relative to the top surface Sa of the sample S, a part of the bottom surface 604 does not contact the sample S. The shield plate 6 may be supported by the shield plate holder 330 such that only the lower edge 603 touches the top surface Sa of the sample S in a manner not illustrated.

The shield plate 6 includes the base plate 2 and tape 4. The tape 4 includes an electrically conductive layer 402 and an adhesive layer 404. The conductive layer 402 is either a foil of a metal (such as aluminum, copper, or carbon) or an electrically conductive thin film such as graphite sheet. The adhesive layer 404 is made of an electrically conductive adhesive.

In the shield plate 6, the shielding surface 602, bottom surface 604, and top surface 606 are formed by the tape 4. The cross-sectional shape of the sample S is affected by the shape of the shielding surface 602. Especially, the shapes of the first tilted surface 602a and the lower edge 603 affect the cross-sectional shape of the sample S. Since the shielding surface 602 and the bottom surface 604 are made of the tape 4 within the shield plate 6, the first tilted surface 602a and the bottom surface 604 can be made creaseless and smooth by replacing the stuck tape 4 with a new one. Accordingly, the sample milling apparatus 300 can achieve cost savings.

Through the use of the above-described shield plate fabrication apparatus 100 or 200, the fabrication plate 6 having the smooth, creaseless first tilted surface 602a and the smooth, creaseless bottom surface 604 can be fabricated easily.

It is to be understood that the present invention is not restricted to the foregoing embodiments but rather can be implemented in various modified forms. For example, the present invention embraces configurations (e.g., configurations identical in function and method) which are substantially identical to the configurations described in the above embodiments. Furthermore, the invention embraces configurations which are similar to the configurations described in the above embodiments except that their nonessential portions have been replaced. Further, the invention embraces configurations which are similar to the configurations described in the above embodiments except that a well-known technique is added.

## Claims

1. A shield plate fabrication apparatus for fabricating a shield plate of a sample milling apparatus which mills a sample by shielding a part of the sample with the shield plate and irradiating the sample with a charged particle beam, said shield plate fabrication apparatus comprising:
a base plate holding shaft for rotatably holding a base plate and winding tape around the base plate; and
a tension mechanism for applying tension to the tape while it is being wound around the base plate.

2. A shield plate fabrication apparatus as set forth in claim 1,
wherein said tension mechanism includes: a sliding member to which one end of said tape is secured; and a spring connected to the sliding member and applying tension to the tape, and
wherein the tape is wound around said base plate from around the other end of the tape by rotating said base plate holding shaft.

3. A shield plate fabrication apparatus as set forth in claim 1,
wherein said tension mechanism comprises an arm to which one end of said tape is secured, an arm securing shaft to which the arm is rotatably secured, and a spring for biasing the arm in a direction opposite to the direction of rotation of said base plate holding shaft when the tape is wound, and
wherein the tape is wound around said base plate from around the other end of the tape by rotating the base plate holding shaft.

4. A shield plate fabrication apparatus as set forth in any one of claims 1 to 3, further comprising:
an enclosure provided with slots for receiving said base plate holding shaft; and
a shaft hold-down member for holding down said base plate holding shaft in such a way that a force opposite in direction to the tension applied to said tape by said tension mechanism is applied to the tape.

5. A shield plate fabrication apparatus as set forth in any one of claims 1 to 4, further comprising a base plate securing spring for pressing said base plate against said base plate holding shaft.

6. A shield plate fabrication apparatus as set forth in any one of claims 1 to 5, further comprising a knob for rotating said base plate holding shaft.

7. A method of fabricating a shield plate of a sample milling apparatus for milling a sample by shielding a part of the sample with the shield plate and irradiating the sample with a charged particle beam, said method comprising the steps of:
mounting a base plate to a base plate holding shaft that rotatably holds the base plate;
laying tape between the base plate held to the base plate holding shaft and a tension mechanism; and
winding the tape around the base plate by rotating the base plate holding shaft while applying tension to the tape by the tension mechanism.

8. A method of fabricating a shield plate as set forth in claim 7, wherein said base plate holding shaft is inserted in slots formed in an enclosure, and wherein during the step of winding the tape around the base plate, said tension mechanism holds down the base plate holding shaft such that a force opposite in direction to the tension applied to the tape by the tension mechanism is applied to the tape.
